Europäisches Patentamt

(19) European Patent Office

Office européen des brevets

(11) Veröffentlichungsnummer: **0 023 295**
**B1**

(12) **EUROPÄISCHE PATENTSCHRIFT**

(45) Veröffentlichungstag der Patentschrift:
13.04.83

(51) Int. Cl.³: **H 03 H 7/48**

(21) Anmeldenummer: **80103982.7**

(22) Anmeldetag: **10.07.80**

(54) **Einrichtung zur gleichmässigen Aufteilung von Hochfrequenzenergie auf zwei Verbraucher.**

(30) Priorität: **25.07.79 DE 2930190**

(43) Veröffentlichungstag der Anmeldung:
**04.02.81 Patentblatt 81/5**

(45) Bekanntmachung des Hinweises auf die Patenterteilung:
**13.04.83 Patentblatt 83/15**

(84) Benannte Vertragsstaaten:
**AT CH DE IT LI NL**

(56) Entgegenhaltungen:
**CH-A-0 468 065**
**DE-A-1 904 644**
**DE-A-2 228 652**
**DE-B-2 807 327**
**FR-A-1 485 034**
**FR-A-1 554 160**

(73) Patentinhaber: **SIEMENS AKTIENGESELLSCHAFT,**
**Berlin und München Wittelsbacherplatz 2,**
**D-8000 München 2 (DE)**

(72) Erfinder: **Badarau, Theodor John, Dipl.-Ing.,**
**Konrad-Celtis-Strasse 21, D-8000 München 70 (DE)**

BUNDESDRUCKEREI BERLIN

Einrichtung zur gleichmäßigen Aufteilung von Hochfrequenzenergie auf zwei Verbraucher

Die Erfindung bezieht sich auf eine Einrichtung, insbesondere für Gemeinschaftsantennen bzw. Kabelfernsehanlagen, zur gleichmäßigen Aufteilung von Hochfrequenzenergie auf zwei gegenseitig entkoppelte, widerstandsgerecht angepaßte Verbraucher, unter Verwendung eines Sparübertragers, der eine Eingangsklemme und eine an Masse liegende Klemme aufweist, und eines Differentialübertragers mit zwei Ausgangsklemmen, wobei beide Übertrager miteinander verbundene Mittelanzapfungen aufweisen und ihre durch Rohrkerne geführten Wicklungen aus Drahtwindungen gebildet sind.

Eine derartige Einrichtung ist aus der DE-AS 28 07 327 vorbekannt. Diese insbesondere für den Einsatz in Gemeinschaftsantennen bzw. Kabelfernsehanlagen vorgesehenen transformatorischen Zweifachverteiler sind dazu bestimmt, eine breitbandige Hochfrequenzenergie gleichmäßig und mit möglichst geringen Verlusten auf zwei Verbraucher, beispielsweise auf zwei abgehende Leitungen aufzuteilen. Dabei wird im Frequenzbereich zwischen 40 und 860 MHz eine impedanzmäßige Anpassung an allen drei Klemmen des Verteilers sowie eine ausreichende gegenseitige Entkopplung zwischen den beiden Ausgangsklemmen gefordert.

Der vorliegenden Erfindung liegt nun die Aufgabe zugrunde, einen Zweifachverteiler mit drahtbewickelten Übertragern zu schaffen, der sich unter Einhaltung der geforderten elektrischen Kennwerte durch einen möglichst einfachen montagefreundlichen Aufbau auszeichnet.

Diese Aufgabe wird ausgehend von einer Einrichtung der eingangs bezeichneten Art erfindungsgemäß in der Weise gelöst, daß für die Wicklungen sowohl des Sparübertragers als auch des Differentialübertragers jeweils U-förmig gebogene Doppeldrahtschleifen verwendet sind, die jeweils durch ein Paar parallel verlaufender Bohrungen eines gemeinsamen Mehrlochkerns geführt sind, daß der Anfang des ersten Einzeldrahtes der dem Sparübertrager zugeordneten Doppeldrahtschleife mit der Eingangsklemme des Sparübertragers, das Ende des zweiten Einzeldrahtes mit Masse und der Anfang des zweiten Einzeldrahtes mit dem den Anzapfpunkt des Sparübertragers bildenden Ende des ersten Einzeldrahtes verbunden ist und daß bei der dem Differentialübertrager zugeordneten Doppeldrahtschleife der Anfang des einen und das Ende des anderen Einzelleiters mit je einer Ausgangsklemme und die beiden übrigen Drahtenden durch Bildung des Mittelanzapfpunktes untereinander, sowie mit dem Anzapfpunkt des Sparübertragers verbunden sind.

Vorteilhafte Weiterbildungen der Erfindung sind in den Unteransprüchen angegeben.

Im folgenden wird ein Ausführungsbeispiel der Erfindung anhand der Zeichnung näher erläutert. Dabei zeigt

Fig. 1 das Ersatzschaltbild für eine Einrichtung gemäß der Erfindung,

Fig. 2 eine Ausführungsform mit einem drahtbewickelten Mehrlochkern,

Fig. 3 eine Isolierstoffhalterung für einen drahtbewickelten Mehrlochkern nach Fig. 2.

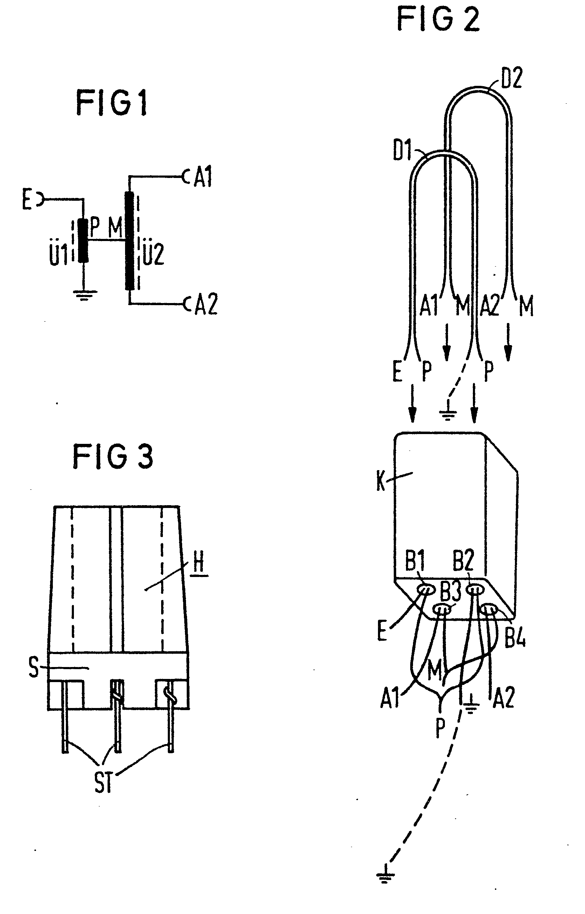

Die Fig. 1 zeigt die Prinzipschaltung eines Zweifachverteilers mit einem Sparübertrager Ü1, dessen Anzapfpunkt P mit dem Mittelanzapfpunkt M eines Differentialübertragers Ü2 verbunden ist. Eingang und die beiden Ausgänge der Schaltung sind mit E und A1, A2 bezeichnet.

Das Wickelschema dieser Übertragungsanordnung ist in Fig. 2 dargestellt. Es zeigt zwei U-förmig gebogene Doppeldrahtschleifen D1 und D2, die jeweils von oben in je ein Paar parallel verlaufender Bohrungen B1, B2 bzw. B3, B4 eines Mehrlochkerns K gesteckt und mit ihren offenen Enden an der Unterseite des Kerns herausgeführt sind. Die Doppeldrahtschleife D1 bildet dabei die Wicklung des Sparübertragers Ü1, wobei der Anfang des ersten Einzeldrahtes mit der Eingangsklemme E des Sparübertragers und das Ende des zweiten Einzeldrahtes mit Masse verbunden ist. Außerdem sind der Anfang des zweiten Einzeldrahtes und das Ende des ersten Einzeldrahtes unter Bildung des Anzapfpunktes P des Sparübertragers Ü1 miteinander verbunden. Zur Erzielung einer widerstandsgerechten Anpassung ist das Übersetzungsverhältnis des Sparübertragers üblicherweise mit $1 : \sqrt{2}$ gewählt. Dadurch wird erreicht, daß die Eingangsimpedanz Z zunächst auf eine Impedanz von Z/2 (Anzapfpunkt P) und schließlich über den nachfolgenden Differentialübertrager wieder auf den Wert Z (Ausgänge A1, A2) transformiert wird. Aufgrund des mit $1 : \sqrt{2}$ gewählten Übersetzungsverhältnisses ergibt sich ein entsprechend ungleiches Windungsverhältnis und damit für den zwischen den Anzapfpunkt und Masse liegenden Wicklungsabschnitt eine höhere Windungszahl. Zu diesem Zweck ist vorgesehen, daß der zweite Einzeldraht der Sparübertrager-Doppeldrahtschleife D1 an einem Ende verlängert und mit seinem verlängerten, nach Masse führenden Endstück ein weiteres Mal durch die beiden zugehörigen Bohrungen B1, B2 des Mehrlochkerns K geführt ist.

Die Wicklungen des Differentialübertragers Ü2 werden durch die zweite Doppeldrahtschleife D2 realisiert. Dabei wird der Anfang des einen Einzelleiters mit dem Ausgang A1 und das Ende des anderen Einzelleiters mit dem Ausgang A2 verbunden. Die beiden verbleibenden Drahtenden werden schließlich durch Bildung des Mittelanzapfpunktes M miteinander, sowie mit dem Anzapfpunkt P des Sparübertragers Ü1 verknüpft.

Die elektrischen Kennwerte des Zweifachverteilers werden u. a. auch von den Eigenschaften des Kernmaterials beeinflußt und können deshalb durch eine gezielte Auswahl des Ferritmaterials in einfacher Weise an den jeweiligen Verwendungszweck angepaßt werden. So kann beispielsweise mit einem Übertragerkern, dessen Anfangspermeabilität μ ca. 650 beträgt, eine Durchgangsdämpfung = 3,5 dB im Frequenzbereich 5—300 MHz erreicht werden. Bei einem anderen Ferritkern, dessen Anfangspermeabilität beispielsweise bei μ = 80 liegt, ergibt sich für die Durchgangsdämpfung ein Wert von = 3,8 dB im Frequenzbereich 40—900 MHz.

Der nach dem Wickelschema gemäß Fig. 2 bewickelte Mehrlochkern K wird schließlich noch in eine Isolierstoffhalterung H eingesetzt, die in Fig. 3 dargestellt ist. Diese Isolierstoffhalterung besteht aus einem etwa rechteckförmigen Sockel mit an den Ecken hochragenden Eckpfeilern, zwischen denen der Mehrlochkern eingebettet und aufgrund der federnden Eigenschaften der Eckpfeiler eingeklemmt wird. Der Mehrlochkern wird nun derart in die Halterung H eingesetzt, daß die Drahtenden der Wicklungen durch eine im Sockel S vorgesehene zentrale Öffnung nach unten hinausragen und mit den an der Unterseite des Sockels vorgesehenen Anschlußstiften ST verbunden werden können.

Infolge des vorgesehenen Wicklungsaufbaus ergibt sich dabei, daß die Enden E und Masse des Sparübertragers Ü1 und die Ausgänge A1 und A2 des Differentialübertragers Ü2 in den Eckpunkten eines Rechtecks aus dem Mehrlochkern heraustreten, so daß sie auf kürzestem Wege jeweils zu einem jedem dieser Eckpunkte zugeordneten Anschlußstift geführt werden können, wodurch die Streuinduktivität klein gehalten werden kann.

Die den Anzapfpunkt P des Sparübertragers und den Mittelanzapfpunkt M des Differentialübertragers Ü2 bildenden Wicklungsenden schließlich werden zur Mitte des durch die Bohrungen B1, B2, B3 und B4 des Mehrlochkerns begrenzten Rechtecks auf der Unterseite des Mehrlochkerns geführt und dort miteinander verdrillt und dann gemeinsam, also miteinander verdrillt zu einem Anschlußstift ST geführt, der sich innerhalb einer Seitenlinie in der Mitte zwischen zwei Anschlußstiften befindet, an die die Wicklungsenden angeschlossen sind. Auf diese Weise werden Unsymmetrieen klein gehalten.

**Patentansprüche**

1. Einrichtung, insbesondere für Gemeinschaftsantennen bzw. Kabelfernsehanlagen, zur gleichmäßigen Aufteilung von Hochfrequenzenergie auf zwei gegenseitig entkoppelte, widerstandsgerecht angepaßte Verbraucher, unter Verwendung eines Sparübertragers (Ü1), der eine Eingangsklemme (E) und eine an Masse liegende Klemme aufweist, und eines Differentialübertragers (Ü2) mit zwei Ausgangsklemmen (A1, A2), wobei beide Übertrager (Ü1, Ü2) miteinander verbundene Mittelanzapfungen (M, P) aufweisen und ihre durch Rohrkerne (K) geführten Wicklungen aus Drahtwindungen gebildet sind, dadurch gekennzeichnet, daß für die Wicklungen sowohl des Sparübertragers (Ü1) als auch des Differentialübertragers (Ü2) jeweils U-förmig gebogene Doppeldrahtschleifen (D1, D2) verwendet sind, die jeweils durch ein Paar parallel verlaufender Bohrungen (B1, B2 bzw. B3, B4) eines gemeinsamen Mehrlochkerns (K) geführt sind, daß der Anfang des ersten Einzeldrahtes der dem Sparübertrager (Ü1) zugeordneten Doppeldrahtschleife (D1) mit der Eingangsklemme (E) des Sparübertragers (Ü1), das Ende des zweiten Einzeldrahtes mit Masse und der Anfang des zweiten Einzeldrahtes mit dem den Anzapfpunkt (P) des Sparübertragers (Ü1) bildenden Ende des ersten Einzeldrahtes verbunden ist und daß bei der dem Differentialübertrager (Ü2) zugeordneten Doppeldrahtschleife (D2) der Anfang des einen und das Ende des anderen Einzelleiters mit je einer Ausgangsklemme (A1, A2) und die beiden übrigen Drahtenden durch Bildung des Mittelanzapfpunktes (M) untereinander sowie mit dem Anzapfpunkt (P) des Sparübertragers (Ü1) verbunden sind.

2. Einrichtung nach Anspruch 1, dadurch gekennzeichnet, daß der zweite Einzeldraht der Sparübertrager-Doppeldrahtschleife (D1) an seinem Ende verlängert und mit seinem verlängerten, nach Masse führenden Endstück wenigstens ein weiteres Mal durch die beiden zugehörigen Bohrungen (B1, B2) des Mehrlochkerns (K) geführt ist.

3. Einrichtung nach Anspruch 1 oder 2, dadurch gekennzeichnet, daß der die Übertrager-Wicklungen tragende Mehrlochkern (K) in eine mit Anschlußstiften (ST) versehene Isolierstoff-Halterung (H) derart eingesetzt ist, daß die Wicklungsenden durch eine zentrale Öffnung eines Sockels der Halterung an die den Bohrungen des Mehrlochkerns zugeordneten und unmittelbar diesen benachbarten Anschlußstifte anschließbar sind.

**Claims**

1. A device, in particular for party antennae and cable television installations, for uniformly distributing high frequency energy between two mutually decoupled loads which are correctly matched in impedance, employing an autotransformer (Ü1) which possesses an input terminal (E) and a terminal connected to earth, and further employing a differential transformer (Ü2) which possesses two output terminals (A1, A2), where both transformers (Ü1, Ü2) possess central tappings (M, P) which are connected to each other, and their windings are formed by wire turns, which lead through tubular cores (K), characterised in that the windings both of the autotransformer (Ü1) and of the differential transformer (Ü2) are each formed by double wire loops (D1, D2) bent into a U-shaped formation, each of which leads through a pair of parallel bores (B1, B2 and B3, B4) of a common multi-perforated core (K), and that the start of the first individual wire of the double wire loop (D1) assigned to the auto-transformer (Ü1) is connected to the input terminal (E) of the auto-transformer (Ü1), the end of the second individual wire is connected to earth, and the start of the second individual wire is connected to that end of the first individual wire which forms the tapping point (P) of the auto-transformer (Ü1), and that in the case of the double wire loop (D2) assigned to the differential transformer (Ü2) the start of the one individual conductor and the end of the other are each connected to an output terminal, whereas the two other wire ends are connected to one another by virtue of the formation of the central tapping point (M) and are likewise connected to the tapping point (P) of the auto-transformer (Ü1).

2. A device as claimed in claim 1, characterised in that the second individual wire of the auto-transformer double wire loop (D1) is extended at its end and its extended end component which leads to earth is conducted at least once more through the two associated bores (B1, B2) of the multi-perforated core (K).

3. A device as claimed in claim 1 or 2, characterised in that the multi perforated core (K) is provided with a socket (H) from isolating material which has connecting pins (ST) and in his center an opening through which the connection-wires of the transformer are fed to the next lying connecting pins (ST) of the socket.

## Revendications

1. Dispositif, en particulier pour des antennes collectives ou pour des installations de télévision par câbles, en vue de la répartition uniforme de l'énergie haute fréquence entre deux charges découplées entre elles et adaptées entre elles du point de vue de la résistance, avec mise en oeuvre d'un autotransformateur (Ü1) qui comporte une borne d'entrée (E) et une borne reliée à la masse, et d'un transformateur différentiel (Ü2) qui comporte deux bornes de sortie (A1, A2), les deux transformateurs (Ü1, Ü2) comportant des prises médianes (M, P) reliées entre elles et leurs enroulements qui passent par des noyaux tubulaires (K) étant formés par des spires de fils de fer, caractérisé par le fait que pour les enroulements, tant de l'autotransformateur (Ü1) que du transformateur différentiel (Ü2), on utilise respectivement des boucles d'un fil double (D1, D2), pliées en forme d'un U et passant respectivement par une paire de perçages parallèles (B1, B2 et B3, B4) d'un noyau commun (K) à plusieurs perçages, que le début du premier fil individuel de la boucle à deux fils (D1) associée à l'autotransformateur (Ü1) est relié à la borne d'entrée (E) de l'autotransformateur (Ü1), l'extrémité terminale du second fil individuel est reliée à la masse et le début du second fil individuel est relié à l'extrémité terminale du premier fil individuel, qui constitue le point de prise (P) de l'autotransformateur, et que dans la boucle à deux fils (D2), qui est associée au transformateur différentiel (Ü2), le début de l'un et l'extrémité terminale de l'autre conducteur individuel sont respectivement reliés à une borne de sortie (A1, A2), alors que les autres extrémités terminales des fils sont reliées entre elles, ainsi qu'avec le point de prise (P) de l'autotransformateur (Ü1).

2. Dispositif selon la revendication 1, caractérisé par le fait que le second fil individuel de la boucle à deux fils (D1) de l'autotransformateur est prolongé à une extrémité, et avec sa partie terminale qui mène à la masse, il passe une seconde fois par les deux perçages associés (B1, B2) du noyau (K) à plusieurs perçages.

3. Dispositif selon la revendication 1 où 2, caractérisé par le fait que le noyau (K) est mis dans un socle (H) produit de material d'isolation pourvoir des pointes de connexion (ST) et aussi pourvoir d'une perforation centrale et que les filets de connexion du transformator sont conduits à travers cette perforation centrale pour permettre une connexion avec les pointes de connexion (ST) voisine.

FIG 1

FIG 2

FIG 3